# EUROPÄISCHE PATENTANMELDUNG

(11) **EP 2 058 603 A2**
(43) Veröffentlichungstag der Anmeldung: **13.05.2009**
(21) Anmeldenummer: 08013802.7
(22) Anmeldetag: 01.08.2008
(51) Int. Cl.: F24J 2/26, H01L 31/052, H01L 31/058

(54) **Einfriersicherer Solarkollector zur simultanen Gewinnung von Wärme und Elektrizität**

(30) Priorität: 06.08.2007 DE 202007010901 U
(71) Anmelder: Brabenec, Maike, 79098 Freiburg (DE)
(72) Erfinder: Stürmer, Hans-Dieter, 68300 Saint-Louis (FR); Brabenec, Maike, 79183 Waldkirch (DE)

(57) **Zusammenfassung**

Die simultane Gewinnung von Strom und Wärme in einem Element wird in einer besonders kostengünstigen Weise dadurch erreicht, dass einem flach konstruierten Photovoltaik-Modul ein Kühlelement von unten durch Anpressen oder Ankleben angefügt wird.

Erfindungsgemäß besteht dieses Element aus einem Metallblech, das in engem Kontakt mit einem wärmebeständigen schlauchförmigen Material gebracht ist, und zwar so, dass dieses sich im Fall des Einfrierens von darin befindlichem Wasser schadlos ausdehnen kann, ohne den Kontakt zum Wärme leitenden Blech zu verlieren.

Lösungsvarianten für die Gestaltung eines solchen Hybridkollektors sind die Verwendung einer omegaförmigen Sicke, oder das Einbringen des Schlauches in einen Hohlraum, der durch Anpressen seiner unteren Hülle, die auch als Wärmedämmung dient, an das Wärmeleitblech gebildet wird. Das Wasser bewirkt durch die Kühlung eine erhöhte Leistung der Solarzellen, und erwärmt dabei seinerseits einen Warmwassertank, der die abgeführte Wärme nutzbar macht. Als besonders geeignetes Schlauchmaterial ist Silikonkautschuk verwendbar, ein besonders geeignetes Dämmmaterial stellt gepresster Polyurethanschaum dar.

## Beschreibung

### Problembeschreibung:

Bei der Gewinnung von Solarenergie wird heute üblicherweise entweder ein Kollektor verwendet, der mit Hilfe einer die Lichtenergie absorbierenden Oberfläche Wärme erzeugt, oder es werden Solarzellen zu Photovoltaik-Modulen zusammengefügt, um Strom zu gewinnen. Bemühungen, in wirtschaftlicher Weise die beiden Funktionen in einem Element zu vereinigen, gab es bereits vor rund 30 Jahren, sie wurden jedoch wegen der dabei auftretenden konstruktiven Probleme nicht zur seriellen Anwendungsreife entwickelt.

Wünschenswert wäre insbesondere eine Kühlung mit dem idealen Wärmeträger Wasser, um durch intensive Kühlung die Leistung von Photovoltaik-Anlagen auf der Basis von mono- oder polykristallinem Silizium zu verbessern. Die dazu heute zumeist verwendeten Schichten zeigen eine Minderung der Leistung von 0,4 bis 0,5 % je Grad Celsius, sodass eine typische ungekühlte Zellentemperatur von 100 °C gegenüber einer gekühlt erreichbaren Temperatur von 50 °C einem Leistungsverlust von über 20 % entspricht. Im Jahresdurchschnitt gehen Simulationen von einer Leistungssteigerung durch Kühlung von etwa 12 bis 15 % aus.

Die Effektivität kann mit Hilfe einer Kühlung auch insoweit weiter gesteigert werden, als dadurch mit Hilfe von Linsen oder Spiegeln auf die Solarzellen konzentriertes Licht verwendet werden kann, ohne den damit normalerweise verbundenen Nachteil der genannten Minderung der Erträge durch Temperaturerhöhung in Kauf nehmen zu müssen.

Klassische Kollektoren zur Kühlung von PV-Anlagen umzurüsten ist sehr aufwändig, da die Oberfläche von Kollektorelementen nicht idealerweise eben gebaut wird. Zudem vermeidet man bei der Konstruktion von Kollektoren elastische Strukturen, während diese gerade bei der Kühlung von PV-Modulen erforderlich wären, um unterschiedliche Wärmedehnungen auszugleichen.

### Problemlösung:

Erfindungsgemäß wird die beschriebene Problematik dadurch gelöst, dass dem PV-Modul von unten ein Blech angedrückt wird, das entweder selbst oder in Kombination mit einem rückwärtigen Element einen Hohlraum bildet, in dem sich ein schlauchförmiges Material befindet, das sich bedarfsweise - etwa beim Einfrieren von Wasser in seinem Inneren - schadlos ausdehnen kann und dabei in Kontakt mit dem genannten Blech bleibt.

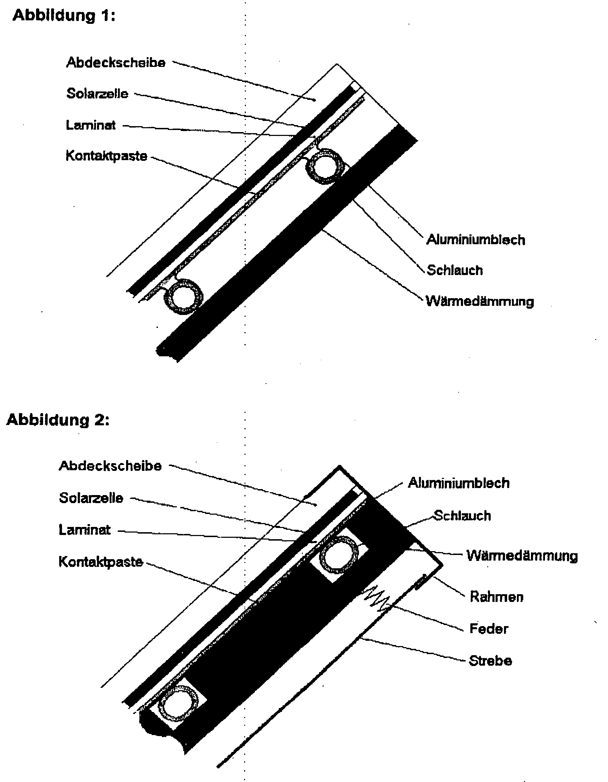

Erfindungsgemäße Möglichkeiten für die Herstellung des genannten Hohlraumes sind zum einen die Formung des Bleches so, dass in gewissen Abständen Sicken eingefügt sind, die im Querschnitt dem großen Omega des griechischen Alphabets ähneln (Abb. 1), oder andererseits das Anpressen eines zweiten Formstückes, beispielsweise aus Polyurethan, das mit dem Blech einen Hohlraum bildet, der das Schlauchmaterial aufnimmt (Abb. 2).

Mit dieser Anordnung wird das bereits in einer früheren Anmeldung (DE OS 28 30 353) genannte Prinzip der Verwendung von Silikonkautschuk oder ähnlichen Materialien als Hüllmaterial in einfrierfesten Sonnenkollektoren (Stürmer 1978) so umgestaltet, dass es für die Kühlung von PV-Modulen auch seine übrigen Vorteile zur Geltung bringen kann, insbesondere die hinsichtlich Einfrieren gefahrlose Verwendbarkeit von Wasser als umweltfreundllchem Wärmeträger hoher Kapazität, die einfache Anbindung von druckarmen Speicherbehältern und die niedrigen Materialkosten.

Das Problem des möglichst engen thermischen Kontaktes zwischen der Rückseite der Zellen und dem wärmeleitenden Metall - zumeist Aluminium - des thermischen Teils wird durch Anpressen und/oder Kontaktieren über eine Wärmeleitpaste bewerkstelligt.

Der thermische Teil wird zweckmäßig in an sich bekannter Weise auf der Rückseite wärmegedämmt. Als besonders geeignet hat sich die Verwendung von gepresstem Schaum aus Polyurethan erwiesen.

## Patentansprüche

1. Ausstattung von photovoltaischen Modulen mit einem wärmeleitfähigen Blech auf der der Sonne abgewandten Seite, **dadurch gekennzeichnet, dass** das Blech mit einem Hohlraum und einem darin befindlichen Schlauchmaterial in Kontakt steht.

2. Ausstattung nach Anspruch 1, **dadurch gekennzeichnet, dass** der Hohlraum durch eine Sicke im Blech gebildet wird, die im Querschnitt dem großen Omega des griechischen Alphabets ähnelt.

3. Ausstattung nach Anspruch 1, **dadurch gekennzeichnet, dass** der Hohlraum durch Anpressen eines Formstückes erreicht wird, das zugleich den Schlauch anpresst.

4. Ausstattung nach einem der vorhergehenden Ansprüche, **dadurch gekennzeichnet, dass** das Wärme leitende Blech angepresst und/oder mit einer Wärmeleitpaste thermisch mit der Rückseite des Photovoltaik-Moduls verbunden wird.

5. Ausstattung nach einem der vorhergehenden Ansprüche, **dadurch gekennzeichnet, dass** sich im Inneren des Schlauches Wasser befindet, das die Solarzellen kühlt und die dabei übertragene Wärme in einen Vorratstank abführt.

6. Ausstattung nach einem der vorhergehenden Ansprüche, **dadurch gekennzeichnet, dass** das Schlauchmaterial aus Silikonkautschuk besteht.

7. Ausstattung nach einem der vorhergehenden Ansprüche, **dadurch gekennzeichnet, dass** die Anordnung mit durch Linsen oder Spiegel aufkonzentriertem Licht beaufschlagt wird.

8. Ausstattung nach einem der vorhergehenden Ansprüche, **dadurch gekennzeichnet, dass** ein aus Polyurethan-Schaumstücken geformtes Material als stabilisierender Dämmstoff verwendet wird.
